# EUROPEAN PATENT APPLICATION

(11) **EP 4 848 925 A1**
(43) Date of publication of application: **02.12.2026**
(21) Application number: 26166620.0
(22) Date of filing: 23.03.2026
(51) Int. Cl.: H10B 20/25

(54) **INTEGRATED CIRCUIT INCLUDING ONE-TIME PROGRAMMABLE MEMORY**

(30) Priority: 28.05.2025 KR 20250069589
(71) Applicant: Samsung Electronics Co., Ltd., Suwon-si, Gyeonggi-do 16677 (KR)
(72) Inventor: KIM, Han-Kyung, 16677 Suwon-si, Gyeonggi-do (KR); LEE, Seungkwon, 16677 Suwon-si, Gyeonggi-do (KR); AN, Hyojoon, 16677 Suwon-si, Gyeonggi-do (KR); KANG, Minji, 16677 Suwon-si, Gyeonggi-do (KR); YU, Hyungwoo, 16677 Suwon-si, Gyeonggi-do (KR); KIM, Sunah, 16677 Suwon-si, Gyeonggi-do (KR)
(74) Representative: Kuhnen & Wacker Patent- und Rechtsanwaltsbüro PartG mbB

(57) **Abstract**

An integrated circuit (40), including first transistors arranged in a first direction (X) and in a second direction (Y) orthogonal to the first direction in a first transistor region (42), and eFuses (eFS) arranged in a fuse region (43) spaced apart from the first transistor region in a third direction (Z) orthogonal to the first direction and the second direction. The eFuses may include a first eFuse including a fuse link between a first electrode electrically connected to at least one of the first transistors in the first transistor region and a second electrode configured to be supplied with a supply voltage.

## Description

### BACKGROUND

### 1. Field of the Invention

Example embodiments relate to an integrated circuit, and specifically, relate to an integrated circuit including one-time programmable (OTP) memory.

### 2. Description of the Related Art

The layout of an integrated circuit has become a more important factor due to advances in semiconductor processes and the demand for high integration density. Particularly, the need for one-time programmable (OTP) memory is growing across various technical fields such as security, communication, and verification. Generally, the circuit structure used to program and read the OTP memory occupies a significant portion of the overall area of the integrated circuit. Accordingly, a layout design method to reduce the size of the OTP memory structure has emerged as an important task to improve both area efficiency and performance of integrated circuits.

### SUMMARY

An aspect provides an integrated circuit including OTP memory with a reduced area.

According to an aspect, there is provided an integrated circuit, including a plurality of first transistors arranged in a first direction and in a second direction orthogonal to the first direction in a first transistor region, and a plurality of eFuses arranged in a fuse region spaced apart from the first transistor region in a third direction orthogonal to the first direction and the second direction. The plurality of eFuses may include a first eFuse including a fuse link between a first electrode electrically connected to at least one of the plurality of first transistors in the first transistor region and a second electrode configured to be supplied with a supply voltage.

According to another aspect, there is provided an integrated circuit including a plurality of bit cells. The plurality of bit cells may include a first bit cell. The first bit cell may include a first read transistor disposed in a first active region extended in a first direction in a first transistor region and including a first gate electrode extended in a second direction orthogonal to the first direction, a first eFuse disposed in a first fuse region spaced apart from the first transistor region in a third direction orthogonal to the first direction and the second direction, and having a first electrode electrically connected to the first read transistor, and a plurality of first program transistors electrically connected to the first electrode of the first eFuse and disposed in a second transistor region adjacent to or spaced apart from the first transistor region in the first direction.

According to another aspect, there is provided an integrated circuit including a plurality of bit cells. At least one bit cell among the plurality of bit cells may include a plurality of first transistors disposed in a first active region extended in a first direction, a plurality of second transistors disposed in a second active region extended in the first direction and sharing gate electrodes extended in a second direction intersecting the first direction with the plurality of first transistors, a plurality of contacts extended in the second direction and overlapping with the first active region and the second active region in a third direction orthogonal to the first direction and the second direction, a plurality of patterns extended in the first direction and disposed in a first wiring layer, each pattern of the plurality of patterns connected to the plurality of contacts, and an eFuse electrically connected to the plurality of first transistors and the plurality of second transistors.

According to example embodiments, it is possible to provide an integrated circuit including a bit cell with improved integration density.

According to example embodiments, it is possible to provide a layout of an integrated circuit with improved integration density and a method of designing the layout. According to example embodiments, it is possible to improve area efficiency and an electrical characteristic of an integrated circuit. According to example embodiments, it is possible to reduce the IR drop of an integrated circuit. According to example embodiments, it is possible to omit a word line repeater. According to example embodiments, it is possible to omit a transition area in an integrated circuit.

Effects resulting from the example embodiments of the present disclosure are not limited to the aforementioned effects, and other effects not mentioned will be clearly derived and understood by those skilled in the art from the example embodiments of the present disclosure.

### BRIEF DESCRIPTION OF THE FIGURES

These and/or other aspects, features, and advantages of the invention will become apparent and more readily appreciated from the following description of example embodiments, taken in conjunction with the accompanying drawings of which:
FIG. 1 is a block diagram illustrating an integrated circuit according to an example embodiment of the present disclosure;
FIG. 2A is a circuit diagram illustrating a bit cell according to an example embodiment.
FIG. 2B is a circuit diagram illustrating a cell array according to an example embodiment.
FIGS. 3A, 3B, and 3C are diagrams illustrating examples of a transistor according to an example embodiment.
FIG. 4 is a diagram illustrating an example of an integrated circuit according to an example embodiment.
FIG. 5 is a top plan view illustrating a layout of an integrated circuit according to an example embodiment.
FIG. 6 is an exemplary cross-sectional view of an integrated circuit taken along line x2-x2' of FIG. 5.
FIG. 7 is an exemplary cross-sectional view of an integrated circuit taken along line y2-y2' of FIG. 5.
FIGS. 8 and 9 are top plan views illustrating layouts of integrated circuits according to an example embodiment.
FIG. 10 is a top plan view illustrating a layout of an integrated circuit according to an example embodiment.
FIGS. 11 and 12 are diagrams illustrating examples of integrated circuits according to an example embodiment.
FIG. 13 is a block diagram illustrating a system-on-chip (SoC) according to an example embodiment of the present disclosure.

### DETAILED DESCRIPTION

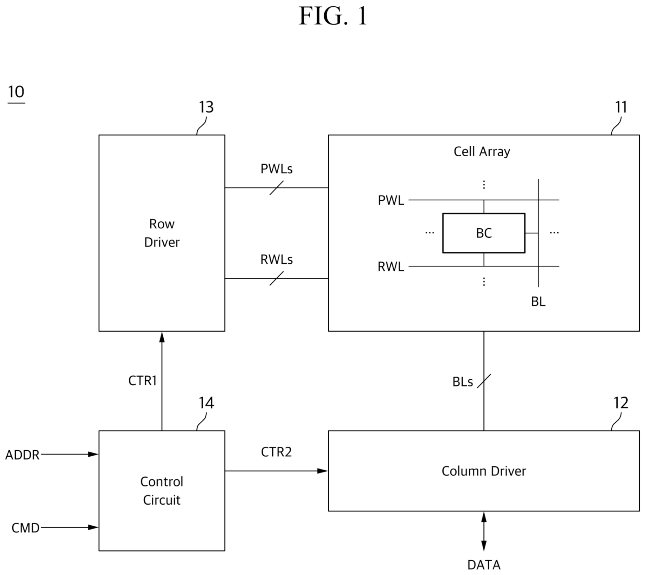

FIG. 1 is a block diagram illustrating an integrated circuit 10 according to an example embodiment of the present disclosure. FIG. 1 is to specifically describe one of various example embodiments of the present disclosure, and for example, the integrated circuit 10 may be implemented as a memory device. The integrated circuit 10 may transmit and receive a command CMD, an address ADDR, and data DATA. For example, the integrated circuit 10 may receive a command CMD, an address ADDR, and data DATA that indicate a program (or write) operation and may store the data DATA in a region of a cell array 11 corresponding to the address ADDR. Furthermore, the integrated circuit 10 may receive a command CMD and an address ADDR that indicate a read operation and read the data DATA stored in the region of the cell array 11 corresponding to the address ADDR and output the data DATA to the outside.

Referring to FIG. 1, the integrated circuit 10 may include the cell array 11, a column driver 12, a row driver 13, and a control circuit 14. The cell array 11 may include a plurality of bit cells. The plurality of bit cells may be arranged at predetermined intervals. In an example embodiment, each of the plurality of bit cells may be electrically connected to at least one of a plurality of word lines PWLs and RWLs, and electrically connected to one of a plurality of bit lines BLs. In an example embodiment, one bit cell BC among the plurality of bit cells may be electrically connected to one program word line PWL and one read word line RWL and electrically connected to one bit line BL. In an example embodiment, the bit cell BC may be a one-time programmable (OTP) memory cell. Specifically, the bit cell BC may be an OTP memory cell of an electrical fuse (eFuse) type. In this case, the bit cell BC may include an eFuse and a plurality of transistors connected to the eFuse. For example, the plurality of transistors may include a program transistor that may open the eFuse and a read transistor to read data corresponding to a state of the eFuse. Meanwhile, it is merely an example embodiment, and the bit cell BC may be implemented as an OTP memory cell of various types such as an antifuse. In an example embodiment, the description about the bit cell BC may be identically applied to another bit cell.

The row driver 13 may be connected to the cell array 11 through the plurality of word lines PWLs and RWLs. The row driver 13 may activate at least one of the plurality of word lines PWLs and RWLs based on a first control signal CTR1. Accordingly, bit cells that are connected to an activated word line among the plurality of bit cells may be selected, and a read operation or a program operation (or a write operation) for the selected bit cells may be performed.

The column driver 12 may be connected to the cell array 11 through the plurality of bit lines BLs. The column driver 12 may perform a read operation or a program operation through the plurality of bit lines BLs based on a second control signal CTR2. During the read operation, the column driver 12 may read data DATA saved in the bit cells connected to the activated word line by detecting a current and/or a voltage received through the plurality of bit lines BLs. During the program operation, the column driver 12 may write data DATA to the bit cells connected to the activated word line by applying a current and/or a voltage through the plurality of bit lines BLs based on data DATA.

The control circuit 14 may receive a command CMD and an address ADDR from an external device. For example, the external device may be a central processing unit (CPU), a digital signal processor (DSP), a graphics processing unit (GPU), a microcontroller (MCU), a communication interface, a memory controller, a processing core, but is not limited thereto. In an example embodiment, the control circuit 14 may identify a program command or a read command by decoding the command CMD. For example, when the program command is identified, the control circuit 14 may generate the first control signal CTR1 and the second control signal CTR2 to save data DATA in at least one bit cell corresponding to an address ADDR. In addition, when the read command is identified, the control circuit 14 may generate the first control signal CTR1 and the second control signal CTR2 to read the data DATA saved in the at least one bit cell corresponding to the address ADDR. The row driver 13 may activate a predetermined word line based on the first control signal CTR1, and the column driver 12 may detect a current and/or a voltage from the plurality of bit lines BLs at a predetermined timing based on the second control signal CTR2.

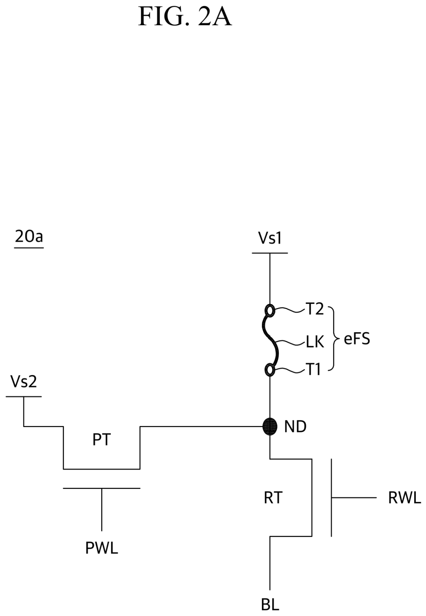

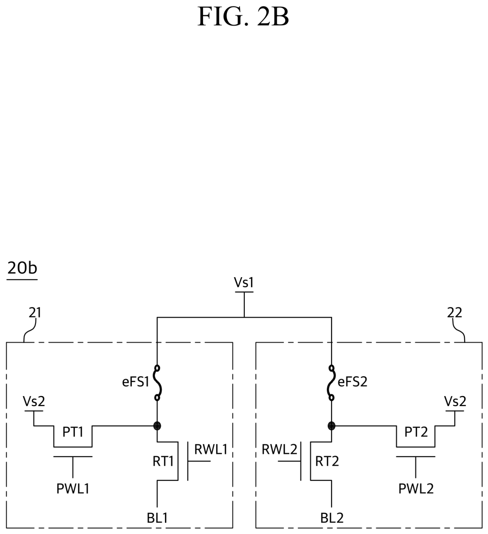

FIG. 2A is a circuit diagram illustrating a bit cell 20a according to an example embodiment. FIG. 2B is a circuit diagram illustrating a cell array 20b according to an example embodiment. The bit cell 20a of FIG. 2A may be an example of the bit cell BC of FIG. 1, and the cell array 20b of FIG. 2B may be an example of the cell array 11 of FIG. 1 to which the bit cell 20a of FIG. 2A. is applied. Meanwhile, the bit cell BC and the cell array 11 of FIG. 1 may not be limited by FIGS. 2A and 2B, but be applied to various circuit diagrams.

Referring to FIG. 2A, the bit cell 20a may include a plurality of transistors and an eFuse eFs. The plurality of transistors may include a program transistor PT and a read transistor RT. The program transistor PT may include a gate, a drain, and a source. The gate of the program transistor PT may be electrically connected to a program word line PWL, and the drain of the program transistor PT may be electrically connected to a node ND, and the source of the program transistor PT may be electrically connected to a second power line that provides a second supply voltage Vs2. The read transistor RT may include a gate, a drain, and a source. The gate of the read transistor RT may be electrically connected to a read word line RWL, and the drain of the read transistor RT may be electrically connected to the node ND, and the source of the read transistor RT may be electrically connected to a bit line BL. The node ND may refer to a common node that electrically connects a first electrode T1 of the eFuse eFs, the drain of the program transistor PT, and the drain of the read transistor RT. In an example embodiment, the program transistor PT and the read transistor RT may be n-channel field effect transistors (NFET), but it is merely an example embodiment, and the program transistor PT and the read transistor RT may be p-channel field effect transistors (PFET) or a combination of NFET and PFET.

The eFuse eFS may include the first electrode T1 (or a first terminal), a second electrode T2 (or a second terminal), and a fuse link LK. The first electrode T1 may be connected to the program transistor PT and the read transistor RT through the node ND. The second electrode T2 may be connected to a first power line, and a first supply voltage Vs1 may be applied to the second electrode T2 from the first power line. The fuse link LK may be connected between the second electrode T2 and the first electrode T1. The fuse link LK may have a structure designed to be electrically opened when a high current flows during a program operation. In an example embodiment, the fuse link LK may include a conductive material, for example, one of various materials such as polysilicon, a metal alloy (for example, an aluminum-copper alloy), a resistive metal oxide (for example: nickel oxide), a carbon-based material (for example, carbon nanotubes or graphene), or a combination thereof. In an example embodiment, the fuse link LK may be referred to as a metal fuse, a metal link, or a metal stripe.

In an example embodiment, the second supply voltage Vs2 may have a higher level than the first supply voltage Vs1. For example, the second supply voltage Vs2 may be a positive supply voltage or a power voltage, and the first supply voltage Vs1 may be a ground voltage or a negative supply voltage. However, it is merely an example embodiment, and the second supply voltage Vs2 may be modified and implemented to have a lower level than the first supply voltage Vs1.

In an example embodiment, the program transistor PT may be configured to provide a current to allow the eFuse eFS to be in an opened state in response to a signal provided through the program word line PWL. For example, during a program operation, the program transistor PT may be turned on due to a voltage applied to a gate through the program word line PWL that is activated. The second supply voltage Vs2 may be provided to the first electrode T1 of the EFuse eFS through the turned-on program transistor PT, and the first supply voltage Vs1 may be provided to the second electrode T2 of the EFuse eFS. Accordingly, as a high current flows through the fuse link LK of the eFuse eFS, an electrical opening may be generated in the fuse link LK. An eFuse eFS in which the electrical opening is generated may have a high resistance value, and an eFuse in which the electrical opening is not generated may have a low resistance value. Whether the eFuse eFS or the fuse link LK is opened or not may indicate data stored in the bit cell 20a.

In an example embodiment, the read transistor RT may be configured to provide data corresponding to a state of the eFuse eFS in response to a signal provided through the read word line RWL. For example, during a read operation, the read transistor RT may be turned on due to a voltage applied to a gate through the read word line RWL that is activated. Depending on whether the eFuse eFS or the fuse link LK is opened or not, a level of a voltage and/or a current of the bit line BL output through the read transistor RT that is turned-on may change. The data stored in the bit cell 20a may be read by sensing the voltage and/or the current of the bit line BL.

Referring to FIG. 2B, the cell array 20b may include a first bit cell 21 and a second bit cell 22. The first bit cell 21 may include a first program transistor PT1, a first read transistor RT1, and a first eFuse eFS1 connected thereto. The second bit cell 22 may include a second program transistor PT2, a second read transistor RT2, and a second eFuse eFS2 connected thereto. The description for the aforementioned bit cell 20a may be identically applied to the first bit cell 21 and the second bit cell 22. The first bit cell 21 and the second bit cell 22 may be connected to independent program word lines PWL1 and PWL2, read word lines RWL1 and RWL2, and bit lines BL1 and BL2, and accordingly, an individual program operation and an individual read operation may be performed.

A second electrode of the first eFuse eFS1 and the second eFuse eFS2 may be commonly connected to a first power line that provides a first supply voltage Vs1. According to an example embodiment, the first eFuse eFS1 and the second eFuse eFS2 may be disposed adjacently, and as the first eFuse eFS1 and the second eFuse eFS2 share a power routing with the first power line, layout efficiency may improve.

FIGS. 2A and 2B illustrate a read transistor and a program transistor within a bit cell as a single transistor, but according to an example embodiment, a single transistor is an equivalent circuit and may correspond to a plurality of transistors that are mutually connected. For example, a plurality of program transistors may be connected in parallel between the node ND and the second power line that provides the second supply voltage Vs2 in the bit cell 20a of FIG. 2A, and a plurality of read transistors may be connected in parallel between the node ND and the bit line BL. The first electrode T1 of the eFuse eFS may be connected to the plurality of program transistors and the plurality of read transistors through the node ND. In this case, drive strength may increase using the plurality of transistors, and accordingly, a greater current to open the eFuse eFS may be quickly applied during a program operation, and a precise and quick detection may be possible by amplifying a small voltage difference during a read operation. Meanwhile, the plurality of read transistors (or the plurality of program transistors) may be connected in various ways, in addition to a parallel connection, such as a differential pair connection.

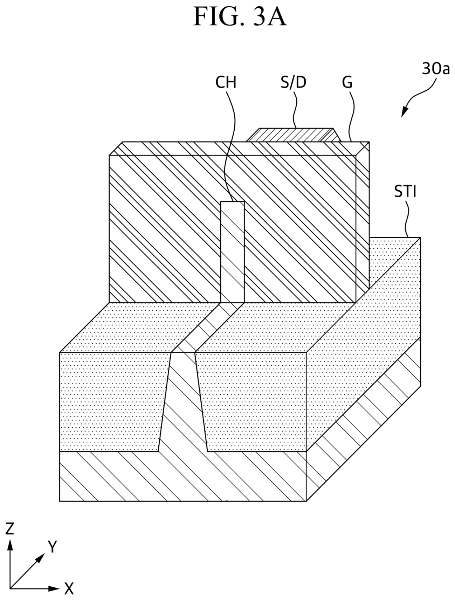

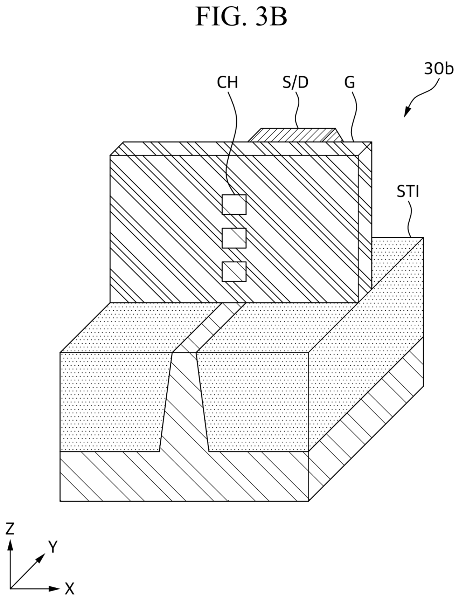

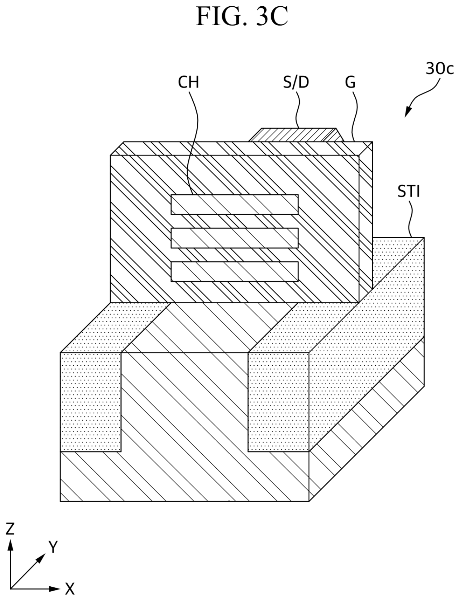

FIGS. 3A, 3B, and 3C are diagrams illustrating examples of a transistor according to an example embodiment. The diagrams in FIGS. 3A, 3B, and 3C illustrate examples of the program transistor PT and the read transistor RT of FIG. 2A. For example, FIG. 3A illustrates a FinFET 30a having a fin, and FIG. 3B illustrates a gate-all-around field effect transistor (GAAFET) 30b, and FIG. 3C illustrates a multibridge channel field effect transistor (MBCFET) 30c. For understanding, FIGS. 3A, 3B, and 3C illustrate that one of two source/drain regions is removed.

Referring to FIG. 3A, the FinFET 30a may be formed by a fin-shaped active pattern extended in a second direction (for example, a Y-axis direction) between a gate G and a shallow trench isolation STI extended in a first direction (for example, an X-axis direction). A source/drain S/D may be formed on both sides of the gate G, and accordingly, the source/drain S/D may be spaced apart from each other in the second direction. A channel CH may be formed between the source/drain S/D. An insulating layer may be formed between the channel CH and the gate G. Meanwhile, the number of active patterns is not limited to what is illustrated in FIG. 3A, but may be modified.

Referring to FIG. 3B, the GAAFET 30b may be formed by active patterns, in other words, by nanowires spaced apart from each other in a third direction (for example, a Z-axis direction) and extended in the second direction, and a gate G extended in the first direction. A source/drain S/D may be formed on both sides of the gate G, and accordingly, the source/drain S/D may be spaced apart from each other in the second direction. An insulating layer may be formed between a channel CH and the gate G. Meanwhile, the number of nanowires is not limited to what is illustrated in FIG. 3B, but may be modified.

Referring to FIG. 3C, the MBCFET 30c may be formed by active patterns, in other words, by nanosheets spaced apart from each other in the third direction and extended in the second direction, and a gate G extended in the first direction. A source/drain S/D may be formed on both sides of the gate G, and accordingly, the source/drain S/D may be spaced apart from each other in the second direction. An insulating layer may be formed between a channel CH and the gate G. Meanwhile, the number of nanosheets is not limited to what is illustrated in FIG. 3C, but may be modified.

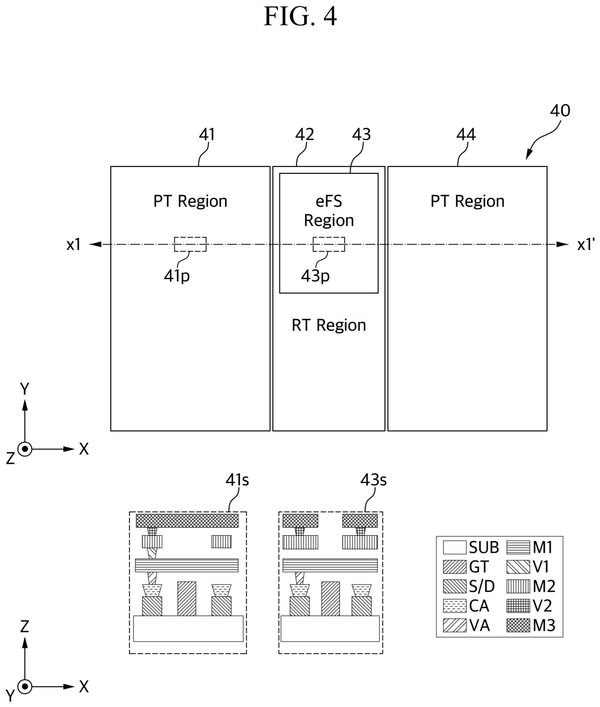

FIG. 4 is a diagram illustrating an example of an integrated circuit 40 according to an example embodiment. FIG. 4 illustrates a top plan view illustrating the integrated circuit 40 and cross-sectional views taken along line x1-x1' together. The integrated circuit 40 may include a first program transistor region 41, a read transistor region 42, an eFuse region 43, and a second program transistor region 44. A first cross-sectional view 41s of FIG. 4 illustrates a portion 41p of the first program transistor region 41, and a second cross-sectional view 43s illustrates a portion 43p in which the read transistor region 42 and the eFuse region 43 overlap. Meanwhile, regions of the integrated circuit 40 are not limited to FIG. 4, but may be arranged in various ways.

Referring to FIG. 4, the first program transistor region 41 and the second program transistor region 44 may be spaced part from each other in a first direction (for example, an X-axis direction). The read transistor region 42 may be disposed between the first program transistor region 41 and the second program transistor region 44. The read transistor region 42 may be a region adjacent to the first program transistor region 41 and the second program transistor region 44 in the first direction.

In an example embodiment, the first program transistor region 41, the read transistor region 42, and the second program transistor region 44 may be extended in a second direction (for example, a Y-axis direction). The term "extended" of the present disclosure may be understood to have a longer form or shape in an extending direction compared to another direction, and is not limited to a straight line, but may be understood as including also a shape such as a curve or a waveform. In an example embodiment, the read transistor region 42 may be referred to as a first transistor region, and the first program transistor region 41 may be referred to as a second transistor region, and the second program transistor region 44 may be referred to as a third transistor region.

In an example embodiment, the eFuse region 43 may be spaced apart from the read transistor region 42 in a third direction (for example, a Z-axis direction), and in other words, the eFuse region 43 may overlap with the read transistor region 42 in the third direction. In an example embodiment, the eFuse region 43 and the read transistor region 42 may be disposed to be spaced apart from each other in the Y-axis direction not to overlap with each other in the third direction. In an example embodiment, the eFuse region 43 may be spaced apart from the first program transistor region 41 in the third direction, and in other words, the eFuse region 43 may overlap with the first program transistor region 41 in the third direction. In an example embodiment, the eFuse region 43 may be referred to as a fuse region.

In this specification, the X-axis direction, the Y-axis direction, and the Z-axis direction may be orthogonal to each other, and the X-axis direction and the Y-axis direction may be referred to as the first direction and the second direction, respectively, and the Z-axis direction may be referred to as a vertical direction or the third direction. A plane formed by an X-axis and a Y-axis may be referred to as a horizontal plane, and an element disposed further in a +Z direction than another element may be described as being positioned above another element, and an element disposed further in a -Z direction than another element may be described as being positioned below another element. In addition, an area of an element may refer to a size that the element occupies on a plane parallel to the horizontal plane, and a width of an element may refer to a length of a direction orthogonal to a direction in which the element is extended. A surface exposed to the +Z direction may be referred to as a top surface, and a surface exposed to the -Z direction may be referred to as a bottom surface, and a surface exposed to a ±X direction or a ±Y direction may be referred to as a side surface. In the diagrams of this specification, only some layers may be illustrated for convenience of illustration, and although a via connecting an upper pattern and a lower pattern is positioned under the upper pattern, the via may be shown for better understanding. In addition, a pattern such as a pattern of a wiring layer that is composed of a conductive material may be referred to as a conductive pattern or simply as a pattern. In this specification, elements electrically connected to each other may be simply referred to as connected.

In an example embodiment, the first program transistor region 41 and the second program transistor region 44 may include a plurality of program transistors arranged in the first direction and the second direction. In an example embodiment, the plurality of program transistors may correspond to the program transistor PT described above in FIG. 2A. For example, the plurality of program transistors may be connected to each other and configured as the program transistor PT. The read transistor region 42 may include a plurality of read transistors arranged in the first direction and the second direction. In an example embodiment, the plurality of read transistors may correspond to the read transistor RT described above in FIG. 2A. For example, the plurality of read transistors may be connected to each other and configured as the read transistor RT. The eFuse region 43 may include at least one eFuse. In an example embodiment, at least one eFuse may correspond to the eFuse eFs described above in FIG. 2A. The eFuse eFs may be referred to as a first eFuse. The first eFuse may include a first electrode, a second electrode, and a fuse link. At least one of read transistors in the read transistor region 42 may be electrically connected to the first electrode of the first eFuse, and program transistors in the first program transistor region 41 may be electrically connected to the first electrode of the first eFuse. As multiple program transistors are connected to the first eFuse, output resistance of a program transistor may be reduced. In an example embodiment, the plurality of transistors arranged in the second program transistor region 44 may be electrically connected to the first electrode of the first eFuse.

In an example embodiment, the first program transistor region 41, the read transistor region 42, the eFuse region 43, and the second program transistor region 44 may be included in one bit cell.

In an example embodiment, the integrated circuit 40 may include at least one of a substrate SUB, vias of a via layer VA formed on a source/drain contact CA formed on a source/drain S/D of a transistor and gate contacts formed on a gate electrode GT, patterns of a first wiring layer M1 formed on the via layer VA, vias of a first via layer V1 formed on the first wiring layer M1, patterns of a second wiring layer M2 formed on the first via layer V1, vias of a second via layer V2 formed on the second wiring layer M2, and patterns of a third wiring layer M3 formed on the second via layer V2. In some example embodiments, the gate contacts may be connected to a pattern of the first wiring layer M1, without passing through a via of the via layer VA.

Referring to the first cross-sectional view 41s and the second cross-sectional view 43s, the gate electrode GT and the source/drains S/D may be formed on the substrate SUB. The gate electrode GT and the source/drains S/D may constitute a transistor (for example, a program transistor or a read transistor). In other words, the transistor may include the gate electrode GT, a channel, and the source/drains S/D. Source/drain contacts CA, the patterns of the first wiring layer M1, the patterns of the second wiring layer M2, and the patterns of the third wiring layer M3 may be sequentially formed on the source/drains S/D. The source/drain contacts CA and the patterns of the first wiring layer M1 may be connected through the vias of the via layer VA formed therebetween. The patterns of the first wiring layer M1 and the patterns of the second wiring layer M2 may be connected through the vias of the first via layer V1 formed therebetween, and the patterns of the second wiring layer M2 and the patterns of the third wiring layer M3 may be connected through the vias of the second via layer V2 formed therebetween. In an example embodiment, the gate contact may be formed on the gate electrode GT and the gate electrode GT and the patterns of the first wiring layer M1 may be connected through the gate contact.

Referring to the second cross-sectional view 43s, the second wiring layer M2 and the third wiring layer M3 may be disposed above the read transistor and the first wiring layer M1. In an example embodiment, the eFuse may be formed between the second wiring layer M2 and the third wiring layer M3. In other words, the eFuse may include the patterns of the second wiring layer M2 and the third wiring layer M3. According to an example embodiment of the present disclosure, the integrated circuit 40 with improved integration density through a stack structure of the eFuse and the transistor may be provided. In addition, as the read transistor is arranged adjacent to the eFuse, a current path may be shortened during a read operation, and accordingly, the IR drop and power consumption may be reduced, and the speed of the read operation may be improved.

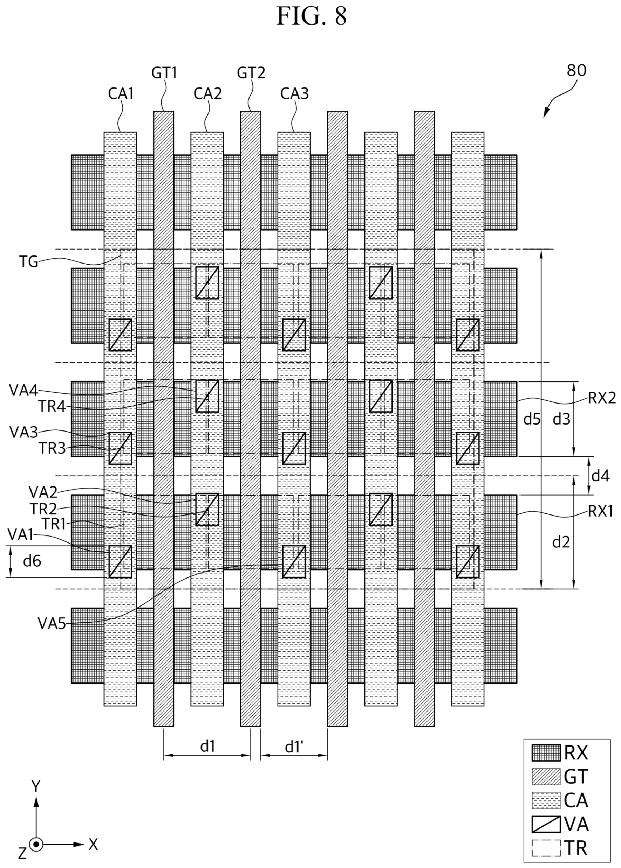

In an example embodiment, first gate electrodes of transistors (in other words, the read transistors) arranged in the read transistor region 42 may be extended in the Y-axis direction. Second gate electrodes of the transistors (in other words, the program transistors) arranged in the first and the second program transistor regions 41 and 44 adjacent to the read transistor region 42 in the X-axis direction may be extended in the Y-axis direction. For example, referring to FIG. 8, a first transistor TR1, a second transistor TR2, a third transistor TR3, and a fourth transistor TR4 may be arranged in the first program transistor region 41, and a first gate electrode GT1 of the first transistor TR1 and the third transistor TR3 and a second gate electrode GT2 of the second transistor TR2 and the fourth transistor TR4 may be extended in a Y-axis direction. In the same manner, transistors may be arranged in the read transistor region 42 adjacent to the first program transistor region 41 in an X-axis direction, and gate electrodes of the transistors may be extended in the Y-axis direction. For example, transistors may be arranged in 2 x 2 in each of the first program transistor region 41 and the read transistor region 42. In this case, the gate electrodes may be extended in the Y-axis direction.

In an example embodiment, a pitch of the gate electrodes in the first program transistor region 41 may correspond to a distance d1 in the X-axis direction in FIG. 8. Likewise, a pitch of gate electrodes in the read transistor region 42 adjacent to the first program transistor region 41 may correspond to the distance d1 in the X-axis direction in FIG. 8. In other words, the pitch of the plurality of gate electrodes in the read transistor region 42 (corresponding to the plurality of first gate electrodes in first transistor region in the claims) may be identical to the pitch of the plurality of gate electrodes in the first program transistor region 41 (corresponding to the plurality of second gate electrodes in the second transistor region in the claims).

In an example embodiment, program transistors of the first program transistor region 41 may include a first program transistor disposed in a first active region extended in the X-axis direction and a second program transistor disposed in a second active region extended in the X-axis direction. For example, referring to FIG. 8, the program transistors of the first program transistor region 41 may include the first transistor TR1 disposed in a first active region RX1 and the third transistor TR3 disposed in a second active region RX2. The first transistor TR1 and the third transistor TR3 may be electrically connected through a first contact CA1 extended in the Y-axis direction. The program transistors of the first program transistor region 41 may include the second transistor TR2 disposed in the first active region RX1 and the fourth transistor TR4 disposed in the second active region RX2. The second transistor TR2 and the fourth transistor TR4 may be electrically connected through a second contact CA2 extended in the Y-axis direction.

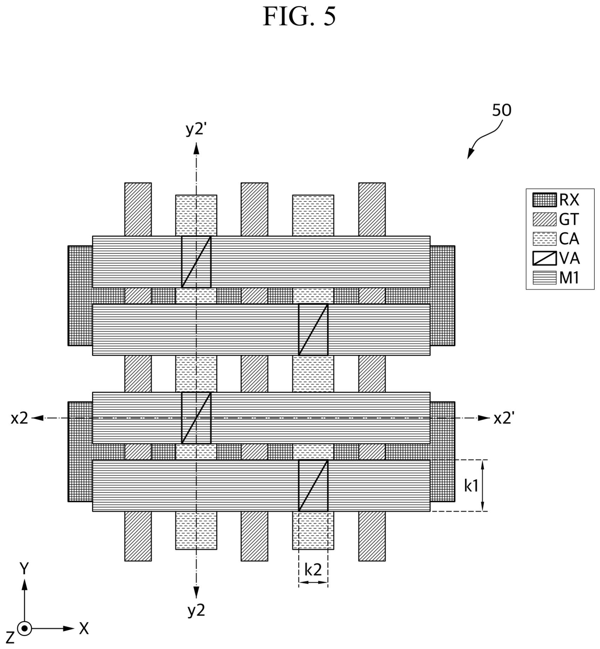

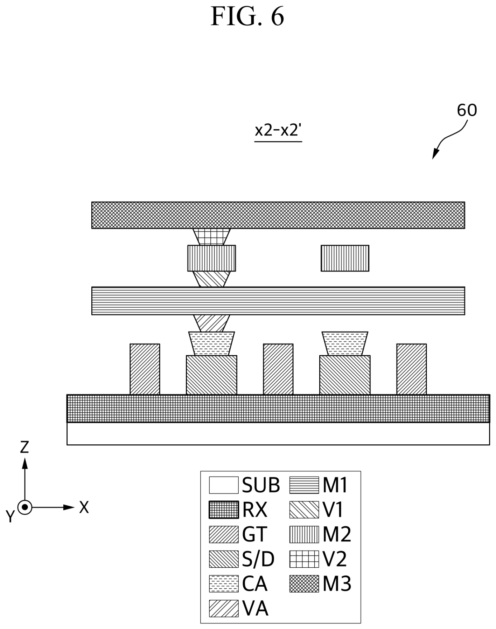

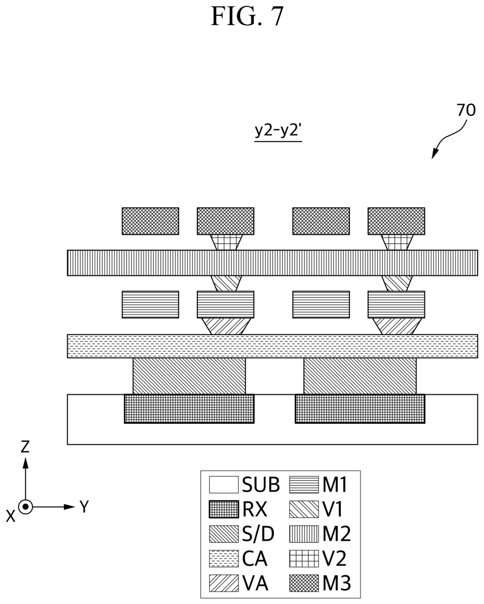

FIG. 5 is a top plan view illustrating an example of an integrated circuit 50 according to an example embodiment. FIG. 6 is an exemplary cross-sectional view of an integrated circuit 60 taken along line x2-x2' of FIG. 5. FIG. 7 is an exemplary cross-sectional view of an integrated circuit 70 taken along line y2-y2' of FIG. 5. FIG. 5 illustrates the first program transistor region 41 or the second program transistor region 44 of FIG. 4, and FIGS. 6 and 7 illustrate cross-sectional views taken along line x2-x2' and line y2-y2', respectively, in the top plan view of FIG. 5 with the second wiring layer M2 and the third wiring layer M3 added. In an example embodiment, an empty space in FIGS. 5, 6, and 7 may be filled with an insulating material or another element. Meanwhile, the integrated circuits 50, 60, and 70 are not limited to FIGS. 5, 6, and 7, and the heights, lengths, and positions of elements within the integrated circuits 50, 60, and 70 may be modified and implemented in various ways. At least some of the descriptions about the integrated circuits 50, 60, and 70 may be identically applied to a read transistor region.

Referring to FIGS. 5, 6, and 7, the integrated circuits 50, 60, and 70 may include active regions RX formed on a substrate SUB. The active regions RX may be extended in an X-axis direction and spaced apart from each other in a Y-axis direction. The active region RX may be an NFET region or a PFET region. Gate electrodes GT may be formed on the active regions RX. The gate electrodes GT may be extended in the Y-axis direction and spaced apart from each other in the X-axis direction. For example, the gate electrodes GT may be extended in the Y-axis direction so as to connect one active region to another active region. In other words, transistors formed in different active regions may share the gate electrode GT extended in the Y-axis direction. In an example embodiment, the length of the gate electrode GT in the Y-axis direction may be equal to or greater than an integer multiple of the length of the active region RX in the Y-axis direction. Here, an integer may be equal to or greater than 2 and may correspond to the number of the active regions RX.

Source/drains S/D may be formed on both sides of the gate electrodes GT. The source/drains S/D may be extended in the Y-axis direction within each of the active region RX. In an example embodiment, the length of the source/drain S/D in the Y-axis direction may be equal to or less than the length of the active region RX in the Y-axis direction. The source/drains S/D may be spaced apart from each other in the X-axis direction.

Source/drain contacts CA may be formed on the source/drains S/D. The source/drain contacts CA may be spaced apart from each other in the X-axis direction. The source/drain contacts CA may be extended in the Y-axis direction. In an example embodiment, the source/drain contacts CA may be extended in the Y-axis direction to connect the source/drains S/D of the active regions RX different from each other. In other words, the source/drain contact CA may electrically connect transistors formed in the active regions RX different from each other. In an example embodiment, the length of the source/drain contact CA in the Y-axis direction may be equal to or greater than an integer multiple of the length of the active region RX in the Y-axis direction. Here, an integer may be equal to or greater than 2 and may correspond to the number of the active regions RX.

Vias of a via layer VA may be formed on the source/drain contacts CA. In an example embodiment, the vias of the via layer VA may have a bar shape. For example, the bar shape may indicate that a cross section of a via is a rectangle with respect to an XY plane. However, it is merely an example embodiment, the cross section of the via with respect to the XY plane may be modified into various shapes such as an oval, a circle, or a polygon.

In an example embodiment, patterns of a first wiring layer M1 may be formed on the vias of the via layer VA. The vias of the via layer VA are illustrated as formed on the patterns of the first wiring layer M1, but it is merely for understanding, and the vias of the via layer VA may be formed below the patterns of the first wiring layer M1 as shown in FIGS. 6 and 7. Vias of a first via layer V1 may be formed on the patterns of the first wiring layer M1. Patterns of a second wiring layer M2 may be formed on the vias of the first via layer V1. Vias of a second via layer V2 may be formed on the patterns of the second wiring layer M2. Patterns of a third wiring layer M3 may be formed on the vias of the second via layer V2. In an example embodiment, the patterns of the first wiring layer M1, the second wiring layer M2, and the third wiring layer M3 may be formed as a mesh structure. For example, referring to FIG. 6, the patterns of the first wiring layer M1 and the third wiring layer M3 may be extended in an X-axis direction, and referring to FIG. 7, the patterns of the second wiring layer M2 between the first wiring layer M1 and the third wiring layer M3 may be extended in a Y-axis direction. According to an example embodiment of the present disclosure, the entire resistance may be reduced compared to a single path due to the mesh structure delivering voltage or current through multiple paths, thereby decreasing the IR drop.

In an example embodiment, the vias of the via layer VA may have a first length k1 in the Y-axis direction, and the first length k1 of a via may correspond to a width of the patterns of the first wiring layer M1. Here, the width may indicate a length in the Y-axis direction. For example, the first length k1 of the via may be substantially identical to a width of the patterns of the first wiring layer M1 on the via. "Substantially identical" may indicate being identical within a margin of error (for example, 2%, 5%, and 10%). However, it is merely an example embodiment, and the first length k1 of the via may be modified and implemented to be shorter than the width of the patterns of the first wiring layer M1. In an example embodiment, the first length k1 of the via of the via layer VA may be longer than a second length k2 in the X-axis direction. However, it is merely an example embodiment, the first length k1 of the via may be modified and implemented to be equal to or shorter than the second length k2.

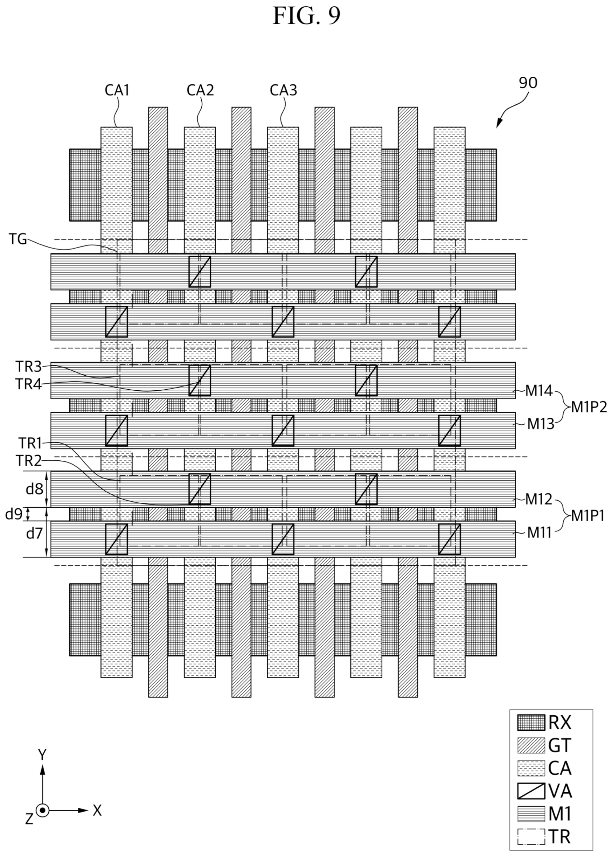

FIGS. 8 and 9 are top plan views illustrating layouts of integrated circuits 80 and 90 according to an example embodiment. A top plan view of FIG. 8 illustrates an example of one of the read transistor region 42, the first program transistor region 41, and the second program transistor region 44 included in the integrated circuit 40 of FIG. 4, and a top plan view of FIG. 9 may indicate an example in which a first wiring layer M1 is formed in a layout of FIG. 8. At least some of the descriptions about the integrated circuits 50, 60, and 70 described above in FIGS. 5, 6, and 7 may be applied to the integrated circuits 80 and 90. Meanwhile, the integrated circuits 80 and 90 may not be limited to FIGS. 8 and 9, but may be modified in various ways.

Referring to FIGS. 8 and 9, the integrated circuits 80 and 90 may include transistors TR. The transistors TR may be disposed on active regions RX extended in the X-axis direction. For example, the transistors TR may include the first transistor TR1, the second transistor TR2, the third transistor TR3, and the fourth transistor TR4, and the active regions RX may include a first active region RX1 and a second active region RX2.

The first transistor TR1 and the second transistor TR2 may be disposed in the first active region RX1 extended in the X-axis direction, and the third transistor TR3 and the fourth transistor TR4 may be disposed in the second active region RX2 extended in the X-axis direction. The first transistor TR1 may be disposed adjacent to the second transistor TR2 in the X-axis direction, and the third transistor TR3 may be disposed adjacent to the fourth transistor TR4 in the X-axis direction.

For example, the first transistor TR1 and the third transistor TR3 may share the first gate electrode GT1 extended in the Y-axis direction, and the second transistor TR2 and the fourth transistor TR4 may share the second gate electrode GT2 extended in the Y-axis direction. Source/drain of the transistors may be formed on both sides of the first gate electrode GT1 and the second gate electrode GT2 on each of the first active region RX1 and the second active region RX2. A drain (or a source) of the first transistor TR1 may share a diffusion region with a source (or a drain) of the second transistor TR2, and a drain (or a source) of the third transistor TR3 may share a diffusion region with a source (or a drain) of the fourth transistor TR4.

The integrated circuits 80 and 90 may be formed on the source/drains of the transistors TR and may include source/drain contacts CA extended in the Y-axis direction. The integrated circuits 80 and 90 may include vias of the via layer VA formed on the source/drain contacts CA. For example, the source/drain contacts CA may include the first contact CA1 and the second contact CA2, and the vias of the via layer VA may include a first via VA1, a second via VA2, a third via VA3, a fourth via VA4, and a fifth via VA5.

The first contact CA1 may be connected to the source of the first transistor TR1 and the source of the third transistor TR3, and the second contact CA2 may be connected to the drain of the first transistor TR1 and the drain of the third transistor TR3. In an example embodiment, the second contact CA2 may be connected to the source of the second transistor TR2 and the source of the fourth transistor TR4, and the source/drain contacts CA may further include a third contact CA3 connected to the drain of the second transistor TR2 and the drain of the fourth transistor TR4. According to an example embodiment, the source/drain contacts CA may have a wire-type shape and a mesh structure together with patterns of the first wiring layer M1 and the like. Accordingly, the integrated circuits 80 and 90 with reduced area and resistance and improved operating speed may be provided.

Referring to FIGS. 8 and 9, the integrated circuit 90 may be formed on the vias of the via layer VA and may include the patterns of the first wiring layer M1 extended in the X-axis direction. The patterns of the first wiring layer M1 may include a first pattern M11, a second pattern M12, a third pattern M13, and a fourth pattern M14. According to an example embodiment, a routing branch may be generated for each cell array due to the mesh structure of the first wiring layer M1, and the IR drop may be reduced.

The first pattern M11 may be electrically connected to the first contact CA1, and for example, the first pattern M11 may be electrically connected to the first contact CA1 through the first via VA1 between the first pattern M11 and the first contact CA1. The second pattern M12 may be electrically connected to the second contact CA2, and for example, the second pattern M12 may be electrically connected to the second contact CA2 through the second via VA2 between the second pattern M12 and the second contact CA2.

In an example embodiment, the first via VA1 of the via layer VA may have a length corresponding to a width of the first pattern M11 in the Y-axis direction, and the second via VA2 of the via layer VA may have a length corresponding to a width of the second pattern M12 in the Y-axis direction. According to an example embodiment, the vias of the via layer VA may have a bar shape corresponding to a width of the patterns of the first wiring layer M1, and accordingly, a contact area may increase to reduce the IR drop.

In an example embodiment, the first pattern M11 and the second pattern M12 of the first wiring layer M1 may overlap with the first active region RX1 in a Z-axis direction, and the third pattern M13 and the fourth pattern M14 of the first wiring layer M1 may overlap with the second active region RX2 in the Z-axis direction. According to an example embodiment, one active region RX and two patterns of the first wiring layer M1 may overlap in the Z-axis direction. The first pattern M11 and the second pattern M12 may constitute a first pattern pair M1P1 overlapping with the first active region RX1, and the third pattern M13 and the fourth pattern M14 may constitute a second pattern pair M1P2 overlapping with the second active region RX2.

In an example embodiment, the via layer VA may include vias disposed between odd-numbered patterns and odd-numbered contacts of the first wiring layer M1. For example, the odd-numbered patterns may include the first pattern M11 and the third pattern M13, and the odd-numbered contacts may include the first contact CA1 and the third contact CA3, and the vias may include the first via VA1 between the first pattern M11 and the first contact CA1, the third via VA3 between the third pattern M13 and the first contact CA1, the fifth via VA5 between the first pattern M11 and the third contact CA3, and a via between the third pattern M13 and the third contact CA3. In an example embodiment, the via layer VA may include vias disposed between even-numbered patterns and even-numbered contacts of the first wiring layer M1. In the same manner, the even-numbered patterns may include the second pattern M12 and the fourth pattern M14, and the even-numbered contacts may include the second contact CA2, and the vias may include the second via VA2 between the second pattern M12 and the second contact CA2 and the fourth via VA4 between the fourth pattern M14 and the second contact CA2. In an example embodiment, the vias of the via layer VA may be arranged in a zig-zag structure or a mosaic structure.

In an example embodiment, the length d1 in the X-axis direction may correspond to a pitch of the gate electrodes GT extended in the Y-axis direction and may be described with the number (or a positive integer) of contact-poly-pitch (CPP) units. A length d1' in the X-axis direction may correspond to a distance between the gate electrodes GT. A length d2 in the Y-axis direction may correspond to a pitch of the transistors TR (or the active regions RX) arranged in the Y-axis direction. In an example embodiment, a length d2 may be determined by a sum of a length d3 and a length d4. The length d3 in the Y-axis direction may correspond to a width of the active region RX. In an example embodiment, the length d3 may be determined by multiplying a width of the transistor TR by an integer m. The integer m may correspond to the number n2 of the transistor TR arranged in the Y-axis direction in the active region RX extended in the X-axis direction. The length d4 in the Y-axis direction may correspond to a distance between the transistors TR (or the active regions RX).

A length d5 in the Y-axis direction may correspond to a width of the source/drain contact CA extended in the Y-axis direction within a unit area. In an example embodiment, the length d5 may be determined by multiplying the length d2 by an integer n. The integer n may correspond to the number of the transistors TR arranged in the Y-axis direction within a unit area. A length d6 in the Y-axis direction may correspond to a width of a via of the via layer VA. For example, the length d6 may be determined by subtracting a length, in which the patterns of the first wiring layer M1 and the via of the via layer VA do not overlap, from a length d8.

A length d7 in the Y-axis direction may correspond to a pitch of the patterns of the first wiring layer M1 extended in the X-axis direction. The length d8 in the Y-axis direction may correspond to a width of the patterns of the first wiring layer M1. A length d9 in the Y-axis direction may correspond to a distance between the patterns of the first wiring layer M1. In an example embodiment, when the length d7 is determined, the length d8 may be determined by multiplying the length d7 by a width ratio w, and the length d9 may be determined by multiplying the length d7 by a space ratio s. Here, w and s are positive numbers, and w + s may be equal to 1. In an example embodiment, when the length d8 and the length d9 are determined, the length d7 may be determined by a sum of the length d8 and the length d9. In an example embodiment, when the length d5 and the length d8 are determined, the length d7 may be determined by multiplying the length d8 by a ratio of the length d5 to the number r of routing tracks of the first wiring layer M1.

In an example embodiment, the transistors TR may be arranged in the X-axis direction and the Y-axis direction in a unit area, and the transistors TR arranged in the unit area may constitute a transistor group TG. The number n1 of transistors TR arranged in the X-axis direction in the unit area may correspond to the length d1, and the number n2 of the transistors TR arranged in the Y-axis direction in the unit area may correspond to the length d2. In an example embodiment, the transistor group TG may perform an operation as a read transistor or a program transistor.

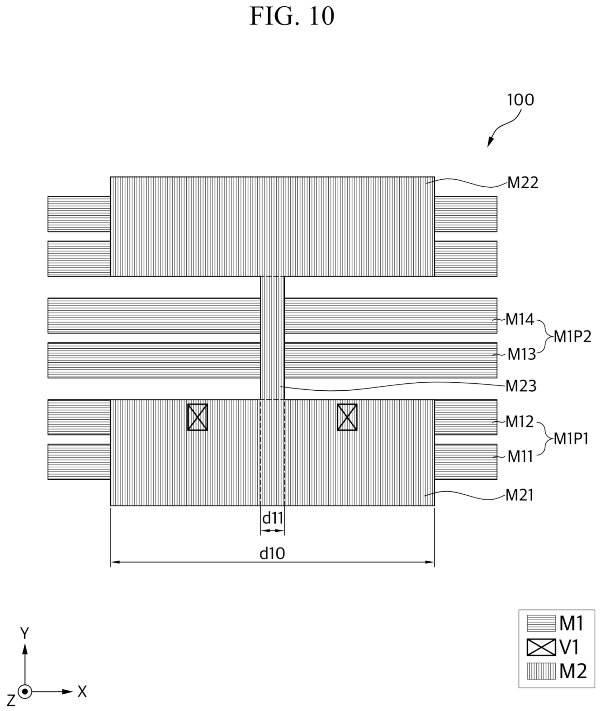

FIG. 10 is a top plan view illustrating a layout of an integrated circuit 100 according to an example embodiment. The top plan view of FIG. 10 illustrates a fuse region, and the top plan view of FIG. 10 illustrates a layout in which a second wiring layer M2 is formed above the first wiring layer M1 of FIG. 9. The fuse region may be formed on the transistor region, and at least one eFuse may be formed in the fuse region. Meanwhile, the integrated circuit 100 is not limited to FIG. 10, but may be modified in various ways.

Referring to FIG. 10, the integrated circuit 100 may include a first pattern M21, a second pattern M22, and a third pattern M23 arranged in the second wiring layer M2. The first pattern M21 may correspond to the first electrode T1 of the eFuse eFS electrically connected to the node ND of FIG. 2A, and the second pattern M22 may correspond to the second electrode T2 of the eFuse eFS to which the first supply voltage Vs1 is applied. The third pattern M23 may correspond to the fuse link LK of the eFuse eFS. In an example embodiment, the second pattern M22 may be spaced apart from the first pattern M21 in a Y-axis direction. In an example embodiment, the third pattern M23 may be extended in the Y-axis direction. A length of the first pattern M21 (or the second pattern M22) in an X-axis direction may be greater than a length d11 of the third pattern M23 in the X-axis direction. Due to such a structure, the third pattern M23 may be opened caused by current focusing on the third pattern M23 during a program operation.

In an example embodiment, the integrated circuit 100 may include vias of a first via layer V1 formed between patterns of the first wiring layer M1 and patterns of the second wiring layer M2. In an example embodiment, the vias of the first via layer V1 may be formed between the first pattern M21 of the second wiring layer M2 and a first pattern pair M1P1 of the first wiring layer M1, and in regions in which the aforementioned vias of the via layer VA overlap in the Z-axis direction.

According to an example embodiment of the present disclosure, a size of a bit cell (or a bit cell kit) may be reduced as a transistor and an eFuse are densely integrated, and as the size of the bit cell is reduced, a word line may be stably operated even if a middle operation circuit such as a word line repeater (or a word line buffer) within a cell array is omitted. In addition, a dummy region may be removed in which a dummy transistor is positioned in an integrated circuit. A transition region used for transition such as RX, RXFIN, MBC may be removed from the integrated circuit, and a global word line structure may be applied. A termination region may be removed from the integrated circuit. Accordingly, the integrated circuit may configure the entire cell array as a shortened channel.

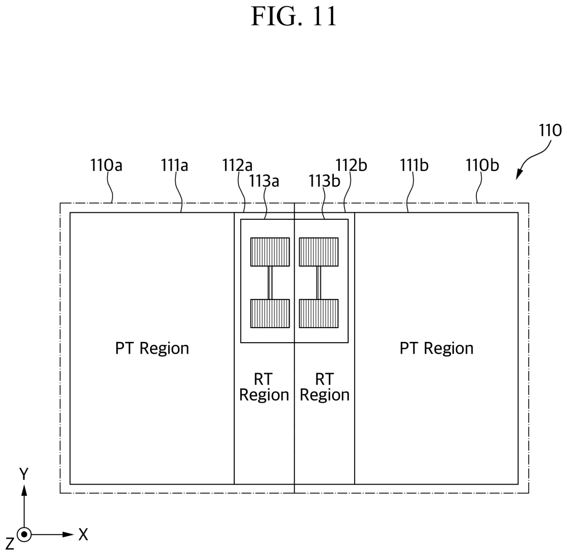

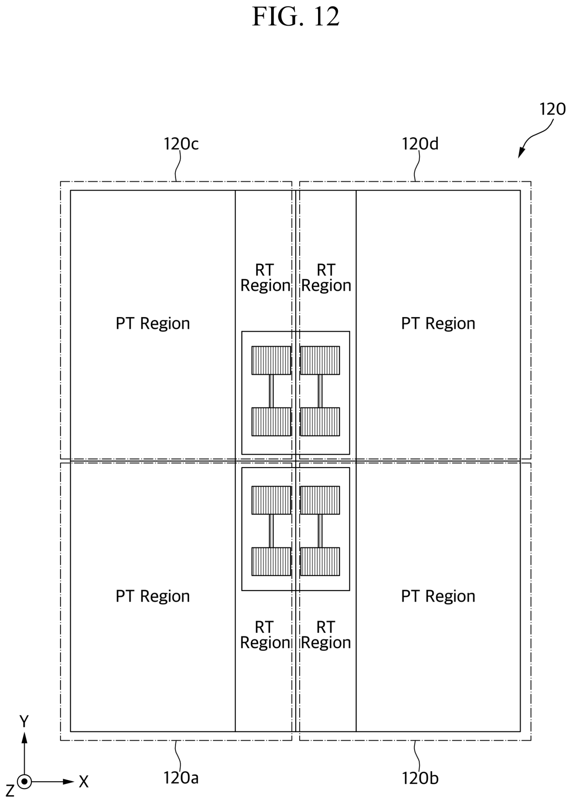

FIGS. 11 and 12 are diagrams illustrating examples of integrated circuits 110 and 120 according to an example embodiment. The integrated circuit 110 of FIG. 11 illustrates an example corresponding to the cell array 20b of FIG. 2B, and FIG. 12 illustrates that two bit cells 120c and 120d are added to the integrated circuit 110 of FIG. 11. Each of the integrated circuits 110 and 120 may include a program transistor arranged in a program transistor region, a read transistor arranged in a read transistor region, and an eFuse arranged in an eFuse region (or a fuse region). The eFuse may include a first electrode, a second electrode, and a fuse link. Repeated description mentioned above about each region will be omitted. Meanwhile, the integrated circuits 110 and 120 are not limited to FIGS. 11 and 12, and a size, a disposition, a position of a wiring layer of patterns corresponding to the eFuse may be modified and implemented in various ways. In an example embodiment, the first read transistor region 112a, the first program transistor region 111a, the second read transistor region 112b, and the second program transistor region 111b may be respectively referred to as a first transistor region, a second transistor region, a third transistor region, and a fourth transistor region.

Referring to FIGS. 11 and 12, the integrated circuits 110 and 120 may include first bit cells 110a and 120a and second bit cells 110b and 120b that are adjacent to each other in an X-axis direction. The first bit cells 110a and 120a may include a first program transistor region 111a, a first read transistor region 112a adjacent to or spaced apart from the first program transistor region 111a in the X-axis direction, and a first eFuse region 113a spaced apart from the first read transistor region 112a in a Z-axis direction. The second bit cells 110b and 120b may include a second program transistor region 111b, a second read transistor region 112b adjacent to or spaced apart from the second program transistor region 111b in the X-axis direction, and a second eFuse region 113b spaced apart from the second read transistor region 112b in the Z-axis direction.

In an example embodiment, the first bit cells 110a and 120a may include a first read transistor, a first eFuse, and a plurality of first program transistors. The first read transistor may be disposed in a first active region extended in the X-axis direction in the first read transistor region 112a and may include a first gate electrode extended in a Y-axis direction. The first eFuse may be disposed in the first fuse region 113a spaced apart from the first read transistor region 112a in the Z-axis direction and may include a first electrode. The plurality of first program transistors may be disposed in the first program transistor region 111a adjacent to or spaced apart from the first read transistor region 112a in the X-axis direction. The first electrode of the first eFuse may be electrically connected to the plurality of first program transistors and the first read transistor. In an example embodiment, the plurality of first program transistors may be configured to provide current to blow the first eFuse in response to a signal provided through a program word line. The first read transistor may be configured to output data corresponding to a state of the first eFuse to a first bit line in response to a signal provided through a read word line.

In an example embodiment, the second bit cells 110b and 120b adjacent to the X-axis direction from the first bit cells 110a and 120a may include a second read transistor, a second eFuse, and a plurality of second program transistors. The second read transistor may be disposed in a second active region extended in the X-axis direction in the second read transistor region 112b adjacent to or spaced apart from the first read transistor region 112a in the X-axis direction and may include a second gate electrode extended in the Y-axis direction. The second eFuse may be disposed in the second fuse region 113b spaced apart from the second read transistor region 112b in the Z-axis direction and may include a first electrode. The plurality of second program transistors may be disposed in the second program transistor region 111b adjacent to or spaced apart from the second read transistor region 112b in the X-axis direction. The first electrode of the second eFuse may be electrically connected to the plurality of second program transistors and the second read transistor. In an example embodiment, a pitch of the first gate electrode in the first read transistor region 112a and another adjacent gate electrode in the first read transistor region 112a may be identical to a pitch of the second gate electrode in the second read transistor region 112b and another adjacent gate electrode in the second read transistor region 112b.

In an example embodiment, the first read transistor region 112a and the second read transistor region 112b may be disposed between the first program transistor region 111a and the second program transistor region 111b. In an example embodiment, a first active region of the first read transistor region 112a and a second active region of the second read transistor region 112b may be connected to each other. In other words, the first active region and the second active region may be a single and continuous active region extended in the X-axis direction. The first eFuse region 113a and the second eFuse region 113b may be disposed adjacently in the X-axis direction. In an example embodiment, the first bit cells 110a and 120a and the second bit cells 110b and 120b may be symmetrically arranged with respect to a boundary.

Referring to FIG. 12, the integrated circuit 120 may include a first bit cell 120a, a second bit cell 120b, a third bit cell 120c, and a fourth bit cell 120d. The first bit cell 120a and the second bit cell 120b may be adjacent to each other in the X-axis direction. The third bit cell 120c may be adjacent to the first bit cells 110a and 120a in the Y-axis direction, and may include third program transistors, a third read transistor, and a third eFuse, which are symmetrically arranged with the first bit cells 110a and 120a with respect to a boundary shared with the first bit cells 110a and 120a. The fourth bit cell 120d may be adjacent to the second bit cells 110b and 120b in the Y-axis direction and adjacent to the third bit cell 120c in the X-axis direction, and may include fourth program transistors, a fourth read transistor, and a fourth eFuse, which are symmetrically arranged with the second bit cells 110b and 120b with respect to the boundary shared with the second bit cells 110b and 120b.

In an example embodiment, one bit cell may include a plurality of first transistors, a plurality of second transistors, a plurality of contacts, a plurality of patterns, and an eFuse. The plurality of first transistors may be disposed in a first active region extended in the X-axis direction. The plurality of second transistors may be disposed in a second active region extended in the X-axis direction. The plurality of second transistors may share gate electrodes, extended in the Y-axis direction intersecting the X-axis direction, with the plurality of first transistors. The plurality of contacts may be extended in the Y-axis direction and may overlap with the first active region and the second active region in the Z-axis direction intersecting with the X-axis direction and the Y-axis direction. The plurality of patterns may be extended in the X-axis direction in a first wiring layer and each of the plurality of patterns may be electrically connected to the plurality of contacts. The eFuse may be electrically connected to the plurality of first transistors and the plurality of second transistors.

In an example embodiment, the eFuse may include a first eFuse pattern arranged in a second wiring layer and electrically connected to the plurality of first transistors and the plurality of second transistors, a second eFuse pattern spaced apart from the first eFuse pattern in the Y-axis direction in the second wiring layer, and configured to be supplied with a supply voltage, and a third eFuse pattern connected between the first eFuse pattern and the second eFuse pattern in the second wiring layer and corresponding to a fuse link.

In an example embodiment, the first program transistor region 111a of the first bit cell 110a may be adjacent to or spaced apart from the first read transistor region 112a in the X-axis direction as shown in FIG. 11, but in another example embodiment, the first program transistor region 111a may be modified and implemented to be adjacent to or spaced apart from the first read transistor region 112a in a +Y-axis direction or a -Y-axis direction. In this case, a program transistor disposed in the first program transistor region 111a may be adjacent to or spaced apart from a read transistor disposed in the first read transistor region 112a in the +Y-axis direction or in the -Y-axis direction. In an example embodiment, the second program transistor region 111b of the second bit cell 110b may be adjacent to or spaced apart from the second read transistor region 112b in the X-axis direction, but in another example embodiment, the second program transistor region 111b may be modified and implemented to be adjacent to or spaced apart from the second read transistor region 112b in the +Y-axis direction or - Y-axis direction.

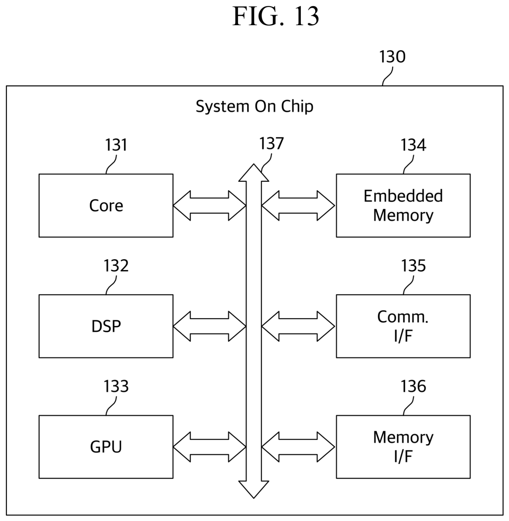

FIG. 13 is a block diagram illustrating a system-on-chip (SoC) according to an example embodiment of the present disclosure. For example, an SoC 130 may be implemented as a device applicable to various application fields such as smartphones, tablets, wearable devices, mobile devices, internet of things (IoT) devices, embedded systems, electronic control units (ECUs), and artificial intelligence accelerators.

Referring to FIG. 13, the SoC 130 according to an example embodiment may include a core 131, a digital signal processor (DSP) 132, a graphics processing unit (GPU) 133, an embedded memory 134, a communication interface (Comm. I/F) 135, a memory I/F 136, and a system bus 137 that interconnects the above components. In an example embodiment, the SoC 130 may additionally include various elements such as a power management unit (PMU), a security engine, a system management controller, a direct memory access (DMA) controller, a clock generating circuit, a timer, and an interrupt controller. Such elements may widen the function of the SoC 130 and support an efficient operation. The aforementioned integrated circuit 10 may be implemented as a form included in at least one of the core 131, the DSP 132, the GPU 133, the embedded memory 134, and the Comm. I/F 135.

The core 131 may function as a central processing unit (CPU) of the SoC 130, execute an instruction, and control the overall operation of the SoC 130. The core 131 may have a single-core or multi-core structure and may be implemented based on various architectures such as advanced RISC machines (ARM) or x86. For example, the core 131 may include various elements such as an instruction pipeline, cache memory, and an instruction decoder.

The DSP 132 may process a digital signal such as an audio, a video, or a communication signal. The DSP 132 may perform operations such as filtering, transformation, and compression. For example, the DSP 132 may include various elements such as a multiplier-accumulator (MAC) unit, a register, and a hardware loop controller.

The GPU 133 may perform a data processing with regard to visual information or an artificial intelligence model such as a two-dimensional (2D) and/or a third-dimensional (3D) graphic rendering and a video encoding/decoding. As excelling at parallel processing, the GPU 133 may efficiently handle data-intensive operations. For example, the GPU 133 may include various elements such as a shader processor, a texture mapping unit, a raster operation unit, a tensor core, and a ray tracing dedicated hardware.

The embedded memory 134 may be a memory module integrated within the SoC 130 and may store data or instructions that a processor such as the core 131 requires. The embedded memory 134 may be implemented as various types of memory such as static random access memory (SRAM), dynamic RAM (DRAM), and flash memory. In some example embodiments, the embedded memory 134 may include bit cells of the integrated circuit 10 described above with reference to the diagrams. Accordingly, the storage capacity and performance of the embedded memory 134 and the SoC 130 may be improved due to high integration density and operating speed of a bit cell.

The Comm. I/F 135 may communicate with an external device of the SoC 130. The Comm. I/F 135 may support various communication protocols such as Universal Serial Bus (USB), Peripheral Component Interconnect Express (PCIe), Universal Asynchronous Receiver/Transmitter (UART), Serial Peripheral Interface (SPI), Inter-Integrated Circuit (I2C), Ethernet, and wireless communication (Wi-Fi and Bluetooth).

The memory interface 136 may communicate with an external device of the SoC 130. The memory interface 136 may manage data exchange with external memory (for example, external DRAM or flash memory). For example, the memory interface 136 may include various elements such as a memory controller and buffer memory.

The system bus 137 may interconnect elements. Various signals such as data, an address, and a control signal may be transmitted through the system bus 137. For example, the system bus 137 may include various elements such as an on-chip interconnect, a bus arbitrator, and a crossbar switch.

## Claims

1. An integrated circuit, comprising:
a plurality of first transistors (RT) arranged in a first direction (X) and in a second direction (Y) orthogonal to the first direction (X) in a first transistor region (42) ; and
a plurality of eFuses (eFS) arranged in a fuse region (43) spaced apart from the first transistor region (42) in a third direction (Z) orthogonal to the first direction (X) and the second direction (Y),
wherein the plurality of eFuses (eFS) includes a first eFuse including a fuse link (LK) between a first electrode (T1) electrically connected to at least one of the plurality of first transistors (RT) in the first transistor region (42) and a second electrode (T2) configured to be supplied with a supply voltage (Vs1).

2. The integrated circuit of claim 1, wherein the plurality of first transistors (RT) in the first transistor region (42) are disposed in a plurality of active regions (RX) extended in the first direction (X).

3. The integrated circuit of claim 1 or 2, further comprising a plurality of second transistors (PT) electrically connected to the first electrode (T1) of the first eFuse and disposed in a second transistor region (41) adjacent to the first transistor region (42) in the first direction (X).

4. The integrated circuit of claim 3, wherein the plurality of second transistors (PT) in the second transistor region (41) includes a first second transistor disposed in a first active region extended in the first direction (X) and a second second transistor disposed in a second active region extended in the first direction (X), and
wherein the integrated circuit further comprises:
a first contact, extended in the second direction (Y) and connected to a source of the first second transistor and a source of the second second transistor; and
a second contact, extended in the second direction (Y) and connected to a drain of the first second transistor and a drain of the second second transistor.

5. The integrated circuit of claim 4, further comprising:
a first pattern, extended in the first direction (X) in a first wiring layer (M1) and electrically connected to the first contact; and
a second pattern, extended in the first direction (X) in the first wiring layer (M1) and electrically connected to the second contact.

6. The integrated circuit of claim 5, wherein the first pattern and the second pattern overlap with the first active region in the third direction (Z), and
wherein the integrated circuit further comprises:
a first via disposed between the first pattern and the first contact; and
a second via disposed between the second pattern and the second contact.

7. The integrated circuit of claim 6, wherein the first via has a first length (k1) corresponding to a width of the first pattern in the second direction (Y), and
wherein the second via has a second length corresponding to a width of the second pattern in the second direction.

8. The integrated circuit of any one of claims 3 to 7, further comprising a plurality of third transistors electrically connected to the first electrode (T1) of the first eFuse, in a third transistor region (44) adjacent to the first transistor region (42) in the first direction (X).

9. The integrated circuit of any one of claims 3 to 8, wherein a plurality of first gate electrodes is extended in the second direction (Y) in the first transistor region (42),
wherein a plurality of second gate electrodes is extended in the second direction (Y) in the second transistor region (41), and
wherein a pitch (d1) of the plurality of first gate electrodes (GT1, GT2) is identical to a pitch of the plurality of second gate electrodes.

10. The integrated circuit of any one of claims 1 to 9, further comprising:
a first pattern (M21), arranged in a second wiring layer (M2) and corresponding to the first electrode (T1); and
a second pattern (M22), spaced apart from the first pattern (M21) in the second direction (Y) in the second wiring layer (M2) and corresponding to the second electrode (T2),
wherein the fuse link (LK) corresponds to a third pattern (M23) connected between the first pattern (M21) and the second pattern (M22).

11. An integrated circuit including a plurality of bit cells, wherein the plurality of bit cells includes a first bit cell (21; 110a; 120a),
wherein the first bit cell (21; 110a; 120a) comprises:
a first read transistor (RT1) disposed in a first active region extended in a first direction (X) in a first transistor region (112a) and including a first gate electrode extended in a second direction (Y) orthogonal to the first direction (X);
a first eFuse (eFS1) disposed in a first fuse region (113a) spaced apart from the first transistor region (112a) in a third direction (Z) orthogonal to the first direction (X) and the second direction (Y), and having a first electrode electrically connected to the first read transistor (RT1); and
a plurality of first program transistors (PT1) electrically connected to the first electrode of the first eFuse (eFS1) and disposed in a second transistor region (111a) adjacent to or spaced apart from the first transistor region (112a) in the first direction (X).

12. The integrated circuit of claim 11, wherein the plurality of bit cells includes a second bit cell (22; 110b; 120b) disposed adjacent to the first bit cell (21; 110a; 120a) in the first direction (X),
wherein the second bit cell (22; 110b; 120b) comprises:
a second read transistor (RT2) disposed in a second active region extended in the first direction (X) in a third transistor region (112b) adjacent to or spaced apart from the first transistor region (112a) in the first direction (X) and including a second gate electrode extended in the second direction (Y);
a second eFuse (eFS2) disposed in a second fuse region (113b) spaced apart from the third transistor region (112b) in the third direction (Z) and having a second electrode electrically connected to the second read transistor (RT2); and
a plurality of second program transistors (PT2) electrically connected to the second electrode of the second eFuse (eFS2) and disposed in a fourth transistor region (111b) adjacent to or spaced apart from the second transistor region (111a) in the first direction (X).

13. The integrated circuit of claim 12, wherein the first transistor region (112a) and the third transistor region (112b) are positioned between the second transistor region (111a) and the fourth transistor region (111b).

14. The integrated circuit of claim 12 or 13, wherein the first active region and the second active region are connected to each other.

15. The integrated circuit of any one of claims 12 to 14, wherein a pitch of the first gate electrode and a first adjacent gate electrode is identical to a pitch of the second gate electrode and a second adjacent gate electrode.
